# EUROPEAN PATENT APPLICATION

(11) **EP 2 407 975 A1**
(43) Date of publication of application: **18.01.2012**
(21) Application number: 10169633.4
(22) Date of filing: 15.07.2010
(51) Int. Cl.: G11B 33/00, G11B 33/02, G11B 33/14, G06F 1/18, H01R 13/658, H05K 9/00

(54) **Removable apparatus for mounting in an opening of a casing**

(71) Applicant: Giga-Byte Technology Co., Ltd., Taipei 231 (TW)
(72) Inventor: Lu, Tung-Ke, 231, Hsin Tien, Taipei County (TW)
(74) Representative: Schwerbrock, Florian

(57) **Abstract**

A removable apparatus for mounted in an opening of a casing includes an upright substrate, two horizontal plates and two vertical plates. The substrate is dimensioned in correlation with dimension of the opening of the casing. The horizontal and vertical plates are formed around the substrate. Each vertical plate includes a body and an elastic sheet. The body has a hole, a front edge and a rear edge at opposite sides of the hole. The elastic sheet has a gentle uphill section extending from the front edge of the body and a sharp downhill section extending from the gentle uphill section. The sharp downhill section is close to the rear edge of the body and hung over the hole of the body and the gentle uphill section has a length larger than that of the sharp downhill section.

## Description

### BACKGROUND OF INVENTION

### 1. Field of Invention

The present invention relates generally to a removable apparatus for mounted in an opening of a casing, and more particularly to a removable apparatus that can be firmly positioned in the casing by the use of elastic sheets.

### 2. Related Prior Art

In general, a removable apparatus is a device that can be mounted in an opening of a casing or be removed from the casing if needed. By this definition, the removable apparatus may be an electronic device, such as a removable hard disk drive, to be installed in the casing or may be a dummy cover that is configured to be mounted in the opening of the casing in order to cover the opening and protect components inside the casing from outside contamination when the casing is not in use. The dummy cover can also be withdrawn from the casing when the casing is about to be used.

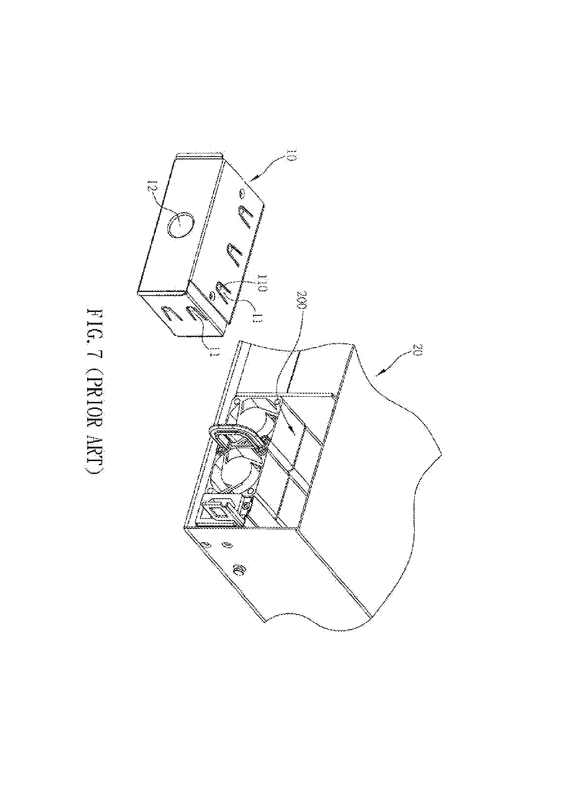

As shown in FIG. 7, a conventional removable apparatus 10, namely a dummy cover, is provided to block a deserted space 200 of a casing 20 in order to protect the internal components inside the casing 20 from contamination. Basically, the removable apparatus 10 is a metallic box with a number of elastic metal sheets 11 on opposed sides thereof. The elastic metal sheets 11 are presented to engage inner walls of the casing 20 upon insertion of the apparatus 10 into the deserted space 200. The elastic metal sheets 11 act to bias the apparatus 10 tightly against the inner walls of the casing 20 and therefore prevent movement of apparatus 10. The apparatus 10 further has a hole 12 defined in the front to facilitate withdrawal of the apparatus 10 from the deserted space 200 of the casing 20 with a user's finger. Noted that, when the apparatus 10 is inserted into the deserted space 200 of the casing 20, it is mainly the bulges 110 formed on the elastic metal sheets 11 that grip the inner walls of the casing 20 to have the apparatus 10 positioned in the deserted space 200 of the casing 20. However, the bonding between the bulges 110 and the walls of the casing 20 is weak that the apparatus 10 may easily get loose within the deserted space 200 once the apparatus 10 is subjected to small external forces or shocks generated from neighboring devices.

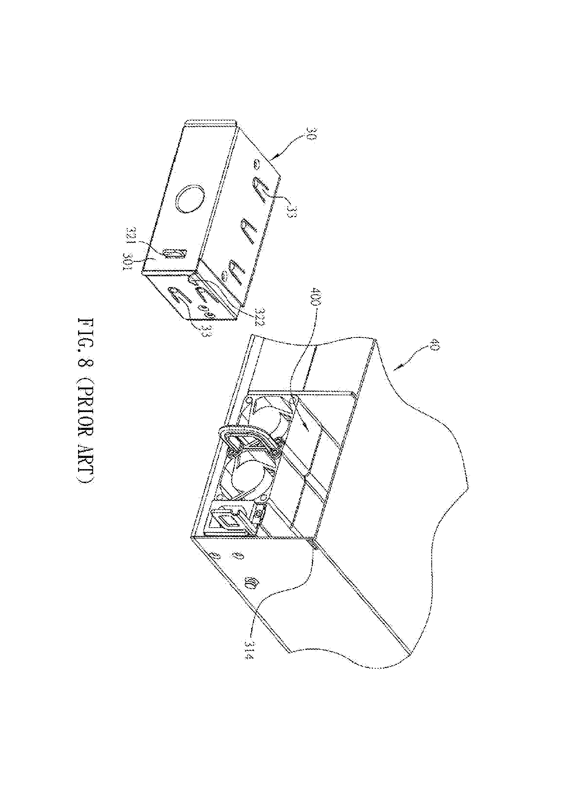

Considering the weak bonding, another removable apparatus 30, as shown in FIG. 8, further includes a locking member 322 that can be fastened in a locking hole 314 of the casing 40 upon insertion of the apparatus 30 into the deserted space 400 of the casing 40 in order to create a strong bonding between the apparatus 30 and the casing 40. However, to fulfill this purpose, the apparatus 30 is relatively complicated in structure and troublesome when it is needed to be detached from the casing 40, as can be seen from the drawing. In that case, a release button 321 appeared in the front needs to be pulled aside first in order to have the locking member 322 released from the locking hole 314 of the casing 40 in such a way that the apparatus 30 can then be detached from the casing 40.

### SUMMARY OF INVENTION

It is an object of the present invention to provide a removable apparatus that can be quickly and efficiently mounted into a casing with strong bonding therebetween and with simple construction.

Broadly stated, the present invention is a removable apparatus for mounted in an opening of a casing. The apparatus may be an electronic device or a dummy cover, which comprises an upright substrate, two opposing horizontal plates and two opposing vertical plates. The substrate is dimensioned in correlation with dimension of the opening of the casing. The two horizontal plates are vertically formed along a top edge and a bottom edge of the substrate respectively. The two vertical plates are vertically formed along opposite side edges of the substrate to engage respective inner walls of the casing upon insertion of the apparatus into the opening of the casing.

Each of the vertical plates includes a body and at least one elastic sheet extending outside the body. The body has at least one hole, a front edge and a rear edge at opposite sides of the hole. The front edge is relatively far from the respective side edge of the substrate and the rear edge is relatively close to the respective side edge of the substrate. The elastic sheet substantially extends over the hole of the body and has a gentle uphill section extending from the front edge of the body and a sharp downhill section extending from the gentle uphill section. The sharp downhill section is close to the rear edge of the body and hung over the hole of the body and the gentle uphill section has a length larger than that of the sharp downhill section.

Preferably, the two horizontal plates may include a plurality of elastic metal sheets thereon to be in contact with the casing or other neighboring devices so as to reduce or eliminate electromagnetic interference.

Further features and advantages of the present invention will be appreciated by review of the following detailed description of the invention.

### BRIEF DESCRIPTION OF DRAWINGS

The invention is illustrated by the accompanying drawings in which corresponding parts are identified by the same numerals and in which:
FIG. 1 is a perspective view of an interior area of a casing in which an embodiment of a removable apparatus in accordance with the present invention is employed to advantage;
FIG. 2 is an enlarged back side view of the removable apparatus;
FIG. 3 illustrates a cross section of the removable apparatus before entering into the casing;
FIG. 4 is a view similar to FIG. 3, illustrating that the removable apparatus is received in the casing;
FIG. 5 illustrates another cross section of the removable apparatus before entering into the casing;
FIG. 6 is a view similar to FIG. 5, illustrating that the removable apparatus is received in the casing with its elastic sheet trapped in a hole of the casing;
FIG. 7 illustrates a prior art; and
FIG. 8 illustrates another prior art.

### DETAILED DESCRIPTION OF EMBODIMENTS

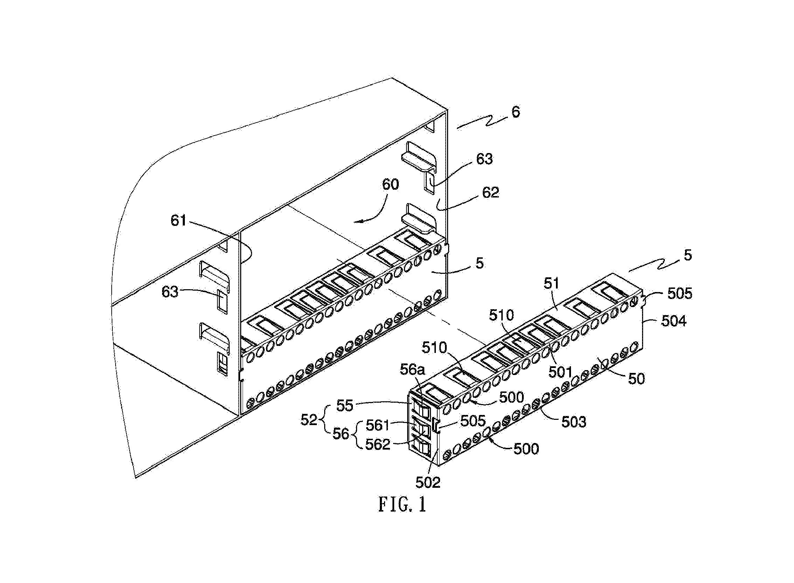

With reference to FIGS. 1 through 6, there is provided at least one removable apparatus 5 to be detachably mounted in a respective opening 60 of a casing 6. As shown in FIG. 1, the casing 60, such as a server housing, has at least three openings 60 defined in a rear surface thereof and situated next to one another. The lowest one of the three openings 60 of the casing 6 has been occupied by a removable apparatus 5 while the middle one is about to be occupied by another outside removable apparatus 5. As can be seen from the drawings, the removable apparatus 5 is, but not limited to, a dummy cover. The removable apparatus, in another example, may be an electronic device, such as a removable hard disk drive or optical disk drive, with specific function. It is noted that the removable apparatus 5 is, but not limited to be, mounted in rear side of the casing 6. In another example, the removable apparatus 5 may be mounted in front side of a casing if necessary.

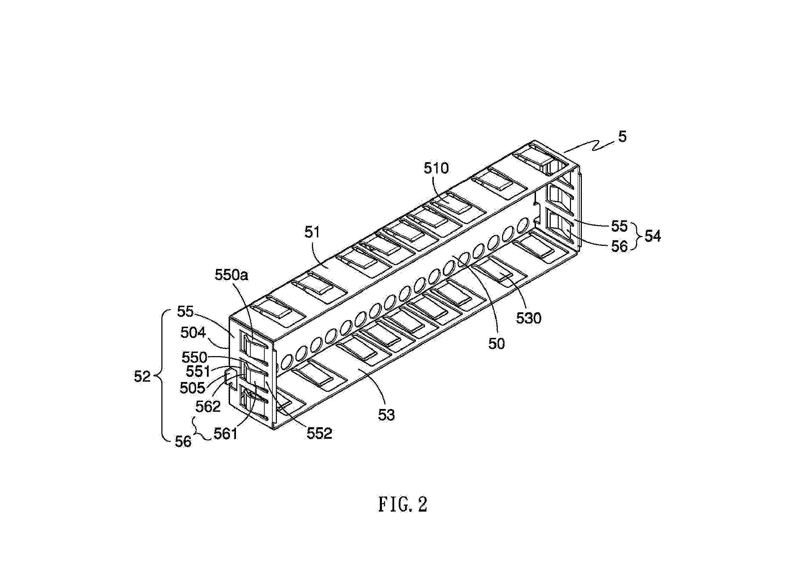

The front and back side views of the removable apparatus 5 can be found in FIGS. 1 and 2. As shown in FIGS. 1 and 2, the removable apparatus 5 includes a right substrate 50, two horizontal plates 51, 53 and two vertical plates 52, 54. The substrate 50 is dimensioned in correlation with dimension of the respective opening 60 of the casing 6 so that the removable apparatus 5 may fit into the opening 60 of the casing 6. Moreover, the substrate 50 has a plurality of small vents 500 through which gases, especially air, can pass. The two horizontal plates 51, 53 face each other and vertically formed along a top edge 501 and a bottom edge 503 of the substrate 50 respectively to be fed into the casing 6. Each of the two horizontal plates 51, 53 has a plurality of elastic metal sheets 510, 530 thereon to reach or contact the casing 6 or other neighboring devices upon insertion of the removable apparatus 5 into the opening 60 of the casing 6, and thereby reduce or eliminate electromagnetic interference (EMI) and ensure the removable apparatus 5 to securely seat in the opening 60. Likewise, the two vertical plates 52, 54 face each other and vertically formed along opposite side edges 502, 504 of the substrate 50 to be fed into the casing for engaging respective inner walls 61, 62 of the casing 6 upon insertion of the removable apparatus 5 into the opening 60 of the casing 6.

As best seen in FIG. 1, the substrate 50 has two lugs 505 formed on opposite side edges 502, 504 thereof and each perpendicular to the adjacent vertical plate 52 or 54 so as to be blocked outside the casing when the removable apparatus 5 is mounted in the opening 60 of the casing 6. That is, when the removable apparatus 5 is fed into the opening 60 of the casing 6, the lugs 505 of the substrate 50 abut against the frame that surrounds the opening 60 of the casing 6 so as to prevent the removable apparatus 5 from completely falling into the casing 6.

As shown in FIG. 2, each of the vertical plates 52, 54 includes a body 55 and at least one elastic sheet 56. Since the vertical plates 52 and 54 are identical in construction except for their location, only the vertical plate 52 will be explained in detail later for purpose of simplification. The body 55 of the vertical plate 52 has at least one hole 550, a front edge 552 and a rear edge 551 and at opposite sides of the hole 550. The front edge 552 of the vertical plate 52 is relatively far from the respective side edge 504 of the substrate 50. The rear edge 551 of the vertical plate 52 is relatively close to the side edge 504 of the substrate 50. On the other hand, the elastic sheet 56 of the vertical plate 52 extends outside the body 55 and substantially over the hole 550 of the body 55. Further, the elastic sheet 56 has a gentle uphill section 561 extending from the front edge 552 of the body 55 and a sharp downhill section 562 extending from the gentle uphill section 561. The sharp downhill section 562 of the elastic sheet 56 is close to the rear edge 551 of the body 55 and hung over the hole 550 of the body 55. Besides, the gentle uphill section 561 has a length larger than that of the sharp downhill section 562.

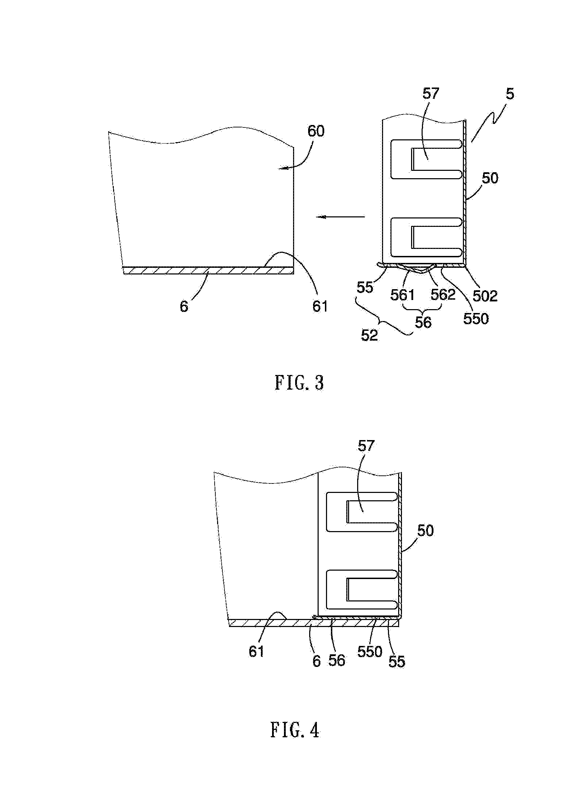

As shown in FIG. 3, when the removable apparatus 5 is about to be fed into the casing 6, it is the gentle uphill section 561 of the elastic sheet 56, rather than the sharp downhill section 562, that will be joined to the casing 6 first. By this way, the removable apparatus 5 encounters small resistance for entering the opening 60 of the casing 6 and can be placed in the opening 60 of the casing 6 easier. As shown in FIG. 4, once the removable apparatus 5 is received in the opening 60 of the casing 6, the elastic sheet 56 stores an elastic force as a result of the pushing of the inner wall 61 of the casing 6 onto the elastic sheet 56. During that pushing, the elastic sheet 56 is forced to move inside a bit and stretch out and finally abuts face-to-face against the inner wall 61 of the casing 6. In other words, the gentle uphill section 561 and the sharp downhill section 562 of the elastic sheet 56 are pressed into the hole 550 of the body 55 of the vertical plate 52 and snugly abut against the inner wall 61 of the casing 6. Because of the stored elastic force, the elastic sheet 56 can bias the apparatus 10 tightly against the inner walls 61 of the casing 6. Therefore, the removable apparatus 5 can be firmly stuck or secured in the casing 6 without the need of the conventional locking member 322 that is commonly employed by the prior art.

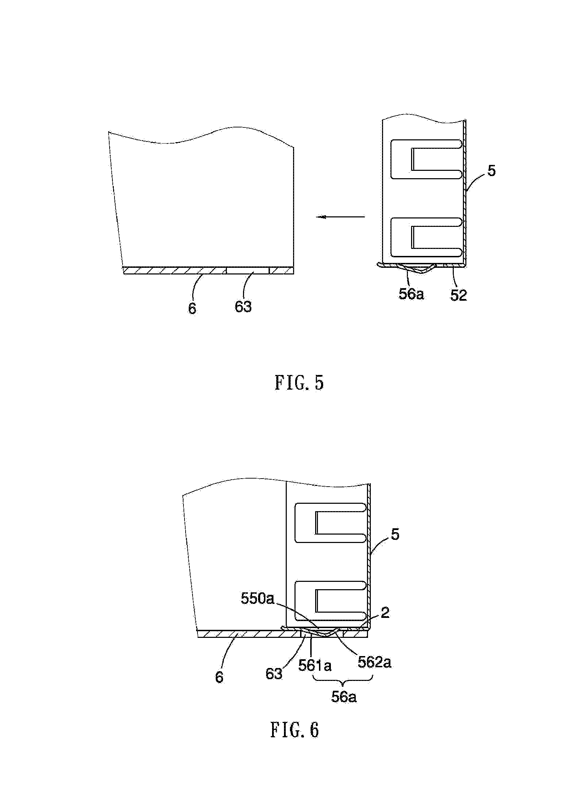

Similar to FIGS. 3-4, FIGS. 5-6 are other cross sectional views according to the present invention, illustrating that another elastic sheet 56a of the vertical plate 52 is to be locked in a hole 63 defined in a side wall of the casing 6. The casing 6 is formed with a number of holes 63, not just one, as depicted in FIG. 1. Those holes 63 of the casing 6 are generally provided for being engaged with fasteners formed on opposite sides of a hard disk drive in order to fasten the hard disk drive onto the casing 6. As such, a user may place the removable apparatus 5 into the casing 6 and have the same positioned in the casing 6 easily. Specifically, as depicted in FIG. 6, the longer gentle uphill section 561a and the shorter sharp downhill section 562a of the elastic sheet 56a are both exactly trapped in the hole 63 of the casing 6. Once being subjected to external forces, shocks or vibrations, the removable apparatus 5 can still rest in the casing 6 since the external forces have to be great enough to pull out all the gentle uphill section 561a and the sharp downhill section 562a from the hole 63 of the casing 6 into the hole 550 of the vertical plate 52 in order to allow the whole removable apparatus 5 be detached from the casing 6. Apparently, the removable apparatus 5 is difficult to be moved out from the casing 6. In other words, the configuration of the gentle uphill section 561a and the sharp downhill section 562a of the elastic sheet 56 trapped in the hole 63 of the casing 6 ensures the removable apparatus 5 to be firmly positioned in the casing 6. As can be understood from these arrangements, if more elastic sheet 56 can be trapped in the holes 63 of the casing 6, the removable apparatus 5 would be positioned in the casing 6 more firmly.

According to the above, the present invention is relatively simple in construction since the conventional locking member 322 is no more needed for the purpose of strong bonding. Moreover, even though the strong bonding exists, the present invention is still a removable from the casing if necessary. Thus, the present invention is easy to be disassembled, repaired and assembled.

It will be appreciated that although a particular embodiment of the invention has been shown and described, modifications may be made. It is intended in the claims to cover such modifications which come within the spirit and scope of the invention.

## Claims

1. A removable apparatus for detachably mounted in an opening of a casing, wherein the opening is defined in a rear surface of the casing and by inner walls of the casing, the removable apparatus comprising:
an upright substrate dimensioned in correlation with dimension of the opening of the casing;
two horizontal plates facing each other and vertically formed along a top edge and a bottom edge of the substrate respectively to be fed into the casing; and
two vertical plates facing each other and vertically formed along opposite side edges of the substrate to be fed into the casing for engaging the respective inner walls of the casing upon insertion of the removable apparatus into the opening of the casing; each vertical plate including a body and at least one elastic sheet; the body having at least one hole, a front edge and a rear edge at opposite sides of the hole; the elastic sheet extending outside the body and substantially over the hole of the body, and having a gentle uphill section extending from the front edge of the body and a sharp downhill section extending from the gentle uphill section, wherein the sharp downhill section is close to the rear edge of the body and hung over the hole of the body, and the gentle uphill section has a length larger than that of the sharp downhill section.

2. The removable apparatus of claim 1, wherein each of the two horizontal plates has a plurality of elastic metal sheets thereon.

3. The removable apparatus of claim2, wherein the substrate has two lugs formed on opposite side edges of the substrate and each perpendicular to the adjacent vertical plate so as to be blocked outside the casing when the removable apparatus is mounted in the opening of the casing.

4. The removable apparatus of claim3, wherein the substrate defines a plurality of vents therein.

5. The removable apparatus as claimed in any one of the claims 1 to 4, wherein when the removable apparatus is mounted in the opening of the casing, the gentle uphill section and the sharp downhill section of the elastic sheet of each vertical plate are exactly trapped in a hole defined in a side wall of the casing.
